(19) Europäisches Patentamt / European Patent Office / Office européen des brevets

(11) EP 3 900 065 B1

(12) **FASCICULE DE BREVET EUROPEEN**

(45) Date de publication et mention de la délivrance du brevet:
**04.06.2025 Bulletin 2025/23**

(21) Numéro de dépôt: **19839646.7**

(22) Date de dépôt: **11.12.2019**

(51) Classification Internationale des Brevets (IPC):
**C09D 127/16** (2006.01)   **C08L 33/06** (2006.01)
**C08K 5/544** (2006.01)   D01D 11/06 (2006.01)

(52) Classification Coopérative des Brevets (CPC):
(C-Sets disponibles)
**C09D 127/16; H10N 30/084; H10N 30/098;
H10N 30/702; H10N 30/857;** D01D 11/06   (Cont.)

(86) Numéro de dépôt international:
**PCT/FR2019/053008**

(87) Numéro de publication internationale:
**WO 2020/128230 (25.06.2020 Gazette 2020/26)**

(54) **FORMULATION DE POLYMÈRE DE GAINAGE D'UNE ÂME MÉTALLIQUE ET PROCÉDÉ DE FABRICATION D'UNE FIBRE PIÉZOÉLECTRIQUE COMPOSITE**

POLYMERFORMULIERUNG ZUR AUSKLEIDUNG EINES METALLKERNS UND VERFAHREN ZUR HERSTELLUNG EINER ZUSAMMENGESETZTEN PIEZOELEKTRISCHEN FASER

POLYMER FORMULATION FOR LINING A METAL CORE AND METHOD FOR PRODUCING A COMPOSITE PIEZOELECTRIC FIBRE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.12.2018 FR 1873569**

(43) Date de publication de la demande:
**27.10.2021 Bulletin 2021/43**

(73) Titulaire: **ARKEMA FRANCE**
**92800 Puteaux (FR)**

(72) Inventeurs:
• **DOMINGUES DOS SANTOS, Fabrice**
**92705 COLOMBES CEDEX (FR)**
• **JESTIN, Simon**
**33600 PESSAC (FR)**

(74) Mandataire: **Arkema Patent**
**Arkema France**
**DRD-DPI**
**51, Esplanade du Général de Gaulle**
**CS 10478**
**92907 Paris La Défense Cedex (FR)**

(56) Documents cités:
**WO-A1-2009/083416     KR-A- 20170 079 516**

• **LIU, W.CHEN, R.RUAN, X.FU, X.: "Polymeric piezoelectric fiber with metal core produced by electrowetting-aided dry spinning method", J. APPL. POLYM. SCI.,** vol. 133, 2016, pages 1 - 8, XP055289419, DOI: 055289419
• **GERARDO ICO ET AL: "Size-dependent piezoelectric and mechanical properties of electrospun P(VDF-TrFE) nanofibers for enhanced energy harvesting", JOURNAL OF MATERIALS CHEMISTRY A,** vol. 4, no. 6, 1 January 2016 (2016-01-01), GB, pages 2293 - 2304, XP055615857, ISSN: 2050-7488, DOI: 10.1039/C5TA10423H

(52) Classification Coopérative des Brevets (CPC):
(Cont.)

C-Sets
**C09D 127/16, C08K 5/544;**
**C09D 127/16, C08K 5/544, C08L 33/06**

## Description

### DOMAINE DE L'INVENTION

La présente invention concerne le domaine des fibres piézoélectriques composites. Plus particulièrement, l'invention se rapporte à des fibres à effet piézoélectrique multi-composant comprenant une écorce de polymère fluoré électroactif qui adhère sur une âme métallique. L'invention concerne aussi une formulation de polymère fluoré en voie solvant qui permet d'obtenir une adhésion optimale sur un filament métallique nu et conducteur électrique. L'invention a trait également au procédé de fabrication de ces fibres composites, ainsi qu'à leurs applications dans des secteurs variés du textile technique, des matériaux composites, de la filtration, et dans l'électronique.

### ARRIERE-PLAN TECHNIQUE

Les matériaux ferroélectriques et ferroélectriques relaxeurs qui génèrent un actionnement mécanique induit par un champ électrique externe ont attiré beaucoup d'attention et ont été reconnus pour des applications dans divers transducteurs, actionneurs et capteurs.

Parmi les matériaux piézoélectriques, les céramiques sont les plus couramment utilisées du fait de leurs bonnes propriétés d'actionnement et de leur bande passante très large. Elles présentent cependant une fragilité qui empêche de les appliquer sur des surfaces courbes ou complexes.

D'autres dispositifs électro-conducteurs utilisent des films polymères en sandwich entre deux électrodes. Parmi les polymères utilisables, les polymères fluorés à base notamment de fluorure de vinylidène (VDF) représentent une classe de composés ayant des propriétés remarquables pour un grand nombre d'applications. Le polyfluorure de vinylidène (PVDF) et les copolymères comprenant du VDF et du trifluoroéthylène (TrFE) sont particulièrement intéressants en raison de leurs propriétés piézoélectriques.

Ces structures flexibles piézoélectriques sont uniquement disponibles commercialement sous forme de films. Certaines applications exigent cependant de disposer de fibres piézoélectriques polymères, qui peuvent être implantées directement au sein de certains matériaux, pour former des matériaux « intelligents » (« smart materials »).

De telles fibres ont été fabriquées au laboratoire sous forme de mono-composant ou multi-composant.

Le filage multi composant de polymères conducteurs et de polymères piézoactifs simultanément permet l'obtention d'une fibre multicouche 100% polymère. Une telle fibre a, par exemple, été décrite par la demanderesse dans la demande WO 2018/224583 qui a trait à une fibre polymère piézoélectrique constituée de trois couches de polymères différents: une couche constituée d'au moins un polymère fluoré, une couche comprenant au moins une polyoléfine et une couche en polyamide.

D'une manière générale, les polymères conducteurs utilisés comme électrodes doivent respecter les critères suivants : pouvoir être mis en œuvre par extrusion ; être suffisamment fluides pour être utilisés dans un procédé de filage ; présenter des températures de filage proches du matériau piézo-électrique constitutif de la fibre, et être suffisamment conducteurs électriques pour assurer une polarisation de la fibre et une récupération efficace des charges générés lors de la déformation du matériau piézo-électrique.

Pour répondre à l'ensemble de ces critères, l'utilisation de compounds (ou composés) polymères conducteurs (abréviés « CPC ») est généralement privilégiée. Cependant, les polymères intrinsèquement conducteurs comme : la polyaniline ; le mélange PEDOT: PSS où PEDOT désigne le poly(3,4-éthylènedioxythiophène) et PSS désigne le poly(styrène sulfonate) ; ou le polypyrole, ne peuvent pas être mis en œuvre en voie fondue. L'homme de l'art va donc réaliser des CPC en utilisant des polymères de grade filage du type : polyamide (PA), polyéthylène (PE), poly(oxyde d'éthylène) (POE), ou poly(téréphtalate d'éthylène (PET), en les associant à des charges conductrices électriques telles que les noirs de carbone, les nanotubes de carbone, les graphènes, les nanofils d'argent ou nanofils métalliques, nanoparticules d'or ou autres.

Bien que la conductivité électrique des granulés de CPC soit en général acceptable (jusqu'à 1000 S/m par exemple), cette valeur décroit très fortement lorsque le matériau est mis en œuvre sous forme de filament, d'un facteur $10^3$ voire $10^6$ dans certains cas. Ce phénomène est principalement dû à l'alignement des charges conductrices durant le procédé de filage ce qui induit une diminution de la percolation électrique de ces charges et donc de la conductivité globale du filament de CPC.

Pour résoudre ce problème, l'utilisation d'une âme métallique (en acier inoxydable, par exemple), revêtue d'un polymère piézoactif amené par extrusion, technique appelée gainage en voie fondue, a été proposée. Cette technique s'avère délicate à mettre en œuvre en pratique. Elle nécessite un polymère piézoactif de faible viscosité à chaud et conduit à des épaisseurs de gainage importantes, supérieures à 100 $\mu$m. Un autre problème réside dans le centrage de l'âme métallique dans la gaine polymère, problème d'autant plus difficile à régler que l'épaisseur recherchée est faible.

Dans le cas de fibres piézoélectriques, des épaisseurs de la couche polymère inférieures à 50 $\mu$m sont recherchées afin d'obtenir une réponse piézoélectrique linéaire en déformation en s'affranchissant du comportement viscoélastique du polymère type PVDF. D'autre part, une épaisseur trop forte de polymère nécessite d'appliquer des tensions de polarisation élevées pouvant être problématiques car entraînant un claquage d'air ou nécessitant un appareillage sophistiqué.

L'utilisation d'un procédé de gainage en voie solvant permet de s'affranchir de ces problèmes de viscosité et d'obtenir des couches de polymère fluoré de plus fine épaisseur, typiquement comprises entre 1 et 30μm. Le principal challenge de cette technique réside dans l'obtention d'une couche adhésive de polymère à la surface du fil métallique, particulièrement lorsqu'on utilise un polymère fluoré.

La publication de Liu, W., Chen, R., Ruan, X. & Fu, X. *"Polymeric piezoelectric fiber with metal core produced by electrowetting-aided dry spinning method."* J. Appl. Polym. Sci. 133, n/a-n/a (**2016**) décrit le gainage en voie solvant assisté par « électro-mouillage » de PVDF ou de copolymère P(VDF-TrFE) sur âme métallique. Un fil de cuivre de 100 μm de diamètre émaillé de polyester-imide (6 μm d'épaisseur) est utilisé comme âme centrale. Un PVDF sous forme de poudre (Mw = 5340000) et un copolymère P(VDF-TrFE) (rapport massique VDF/TrFE : 70-30) sont mis en solution dans un mélange diméthylformamide- acétone 1 :1, en concentration de 10, 15 et 20w%. Le fil émaillé passe dans une solution de polymère et dans une aiguille en cuivre de 1 mm de diamètre puis dans une série d'électrodes concentriques de 3,5 mm à 0,5 mm. La filière de gainage est polarisée à 1kV. Le cœur en cuivre dénudé de son émaillage est relié à la masse et les électrodes sont reliées à une haute tension continue de 4kV. Le champ appliqué est inférieur à 20 MV/m. La cristallisation du polymère se fait par évaporation de solvant. La fibre obtenue est métallisée à l'or en pulvérisation cathodique. Les auteurs montrent que l'utilisation du procédé électromouillage permet d'obtenir des couches de polymère sur cuivre plus homogènes, lisses et adhésives que sans haute tension. Les couches utilisant le P(VDF-TrFE) à 15% sont plus homogènes que les couches de PVDF. La phase beta est obtenue lorsque le champ électrique est appliqué. Des épaisseurs de gaine comprises entre 3 et 8 μm sont obtenues avec la plupart des solutions utilisées. L'homogénéité de l'épaisseur est améliorée en utilisant la haute tension. Ce procédé reste néanmoins compliqué à utiliser et met en œuvre des hautes tensions électriques durant la fabrication. De plus, aucune preuve de l'adhésion du polymère fluoré au fil émaillé n'a été apportée, comme par exemple une image de microscopie de la section des filaments obtenus.

Il existe donc un besoin de mettre au point une formulation de gainage à base de polymère fluoré qui permet d'obtenir une adhésion optimale sur un filament métallique nu et conducteur électrique, au moyen d'un procédé simple de gainage de filament en continu, par un polymère piézo-électrique en voie solvant, sans émaillage, ni revêtement préalable. L'invention vise également à fournir des fibres à effet piézo-électrique multi-composant comprenant une écorce de polymère fluoré électroactif qui adhère sur une âme métallique.

RESUME DE L'INVENTION

L'invention concerne en premier lieu une formulation polymère de gainage d'une âme métallique telle que définie dans la revendication 1.

Selon un mode de réalisation, le copolymère P(VDF-TrFE) consiste en des unités issues du VDF et du TrFE, la proportion de motifs issus du TrFE allant de 5 à 95 mol.% par rapport à la somme des motifs issus du VDF et du TrFE.

L'agent tensioactif permet d'assurer un mouillage optimal de la solution de copolymère fluoré sur l'âme métallique.

Le promoteur d'adhésion contribue à l'amélioration du mouillage de la solution de copolymère fluoré sur l'âme métallique, et permet également d'obtenir une gaine adhésive de copolymère sur le filament. Il s'agit d'un polymère fonctionnalisé avec des groupements de type $-NH_2$, -OH, -COOH ou autres groupements associatifs.

Selon un mode de réalisation, une solution montrant un comportement rhéo-épaississant est avantageuse.

L'invention concerne également un procédé de fabrication en continu, en voie solvant, d'une fibre piézoélectrique composite comprenant un filament métallique recouvert d'une couche de polymère fluoré piézoélectrique, ledit procédé comprenant les étapes suivantes :

    i) fournir un fil métallique nu,
    ii) enduire ledit fil métallique avec la formulation de gainage selon l'invention, comprenant le passage dudit fil métallique dans une filière de gainage où est injectée ladite formulation de gainage, pour obtenir un fil métallique gainé,
    iii) sécher ledit fil métallique gainé pour évaporer le solvant,
    iv) chauffer le film métallique gainé séché pour réaliser un recuit thermique.

Le procédé peut comprendre en outre une étape v) de bobinage du fil métallique gainé, qui peut être réalisée soit avant l'étape de recuit thermique, soit après cette étape.

Le fil métallique joue le rôle d'électrode interne. Diverses utilisations de ce fil piézoélectrique composite nécessitent le dépôt d'une électrode externe sur la gaine en polymère.

Selon un mode de réalisation, le procédé selon l'invention comprend une étape supplémentaire vi) de recouvrement en continu du fil métallique gainé par une contre-électrode. Cette opération de dépôt d'électrode externe peut avantageusement être conduite en ligne à la suite des étapes de séchage et de recuit précédemment décrites, avant l'étape de bobinage.

Le procédé selon l'invention comprend en outre une étape vii) de polarisation du polymère piézo-électrique déposé à la surface de l'âme métallique. Cette polarisation peut se faire de plusieurs façons, soit avant soit après le dépôt de l'électrode externe.

Le procédé selon l'invention peut produire une fibre piézoélectrique composite comprenant une écorce de polymère fluoré électroactif qui adhère sur une âme métallique. Avantageusement, la fibre présente une déformation élastique comprise entre 1 et 5%.

La fibre piézoélectrique composite peut être utilisée dans diverses applications comme les matériaux composites instrumentés, la fabrication de textiles techniques, la fabrication d'articles textiles, la filtration des fluides, et dans l'électronique.

La présente invention permet de surmonter les inconvénients de l'état de la technique. En particulier, l'invention fournit une formulation de gainage à base de polymère fluoré qui permet d'obtenir une adhésion optimale sur un filament métallique nu et conducteur électrique, sans nécessiter un émaillage ou revêtement préalable pour accroche. Cette formulation de gainage est mise en œuvre grâce à un procédé de fabrication simple de gainage de filament en continu par un polymère piézoélectrique en voie solvant. Ce procédé est facilement industrialisable et ne nécessite pas la modification des propriétés de mouillage de la surface du fil métallique nu par l'application d'une tension électrique (électromouillage).

FIGURES

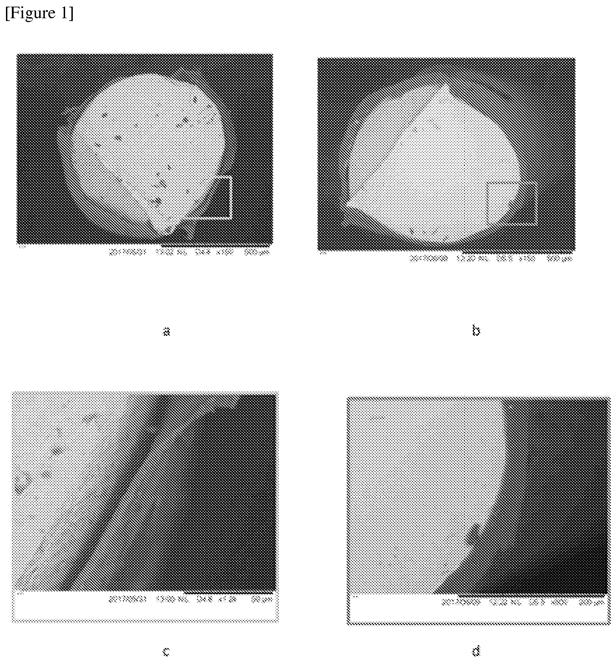

La Figure 1 représente les clichés de microscopie électronique à balayage sur des filaments de cuivre de 700 $\mu$m diamètre, gainés par une couche de formulation à base de 20% copolymère P(VDF-TrFE) dans la MEK. Les images b et d se rapportent à des fibres selon l'invention, dont les couches de gainage contiennent un agent tensioactif (1%) et un promoteur d'adhésion (0,25%). Les images a et c se rapportent à des fibres comparatives, dont les couches de gainage sont dépourvues d'agent tensioactif et de promoteur d'adhésion. L'image 1c est un agrandissement de l'image la. L'image 1d est un agrandissement de l'image 1b.

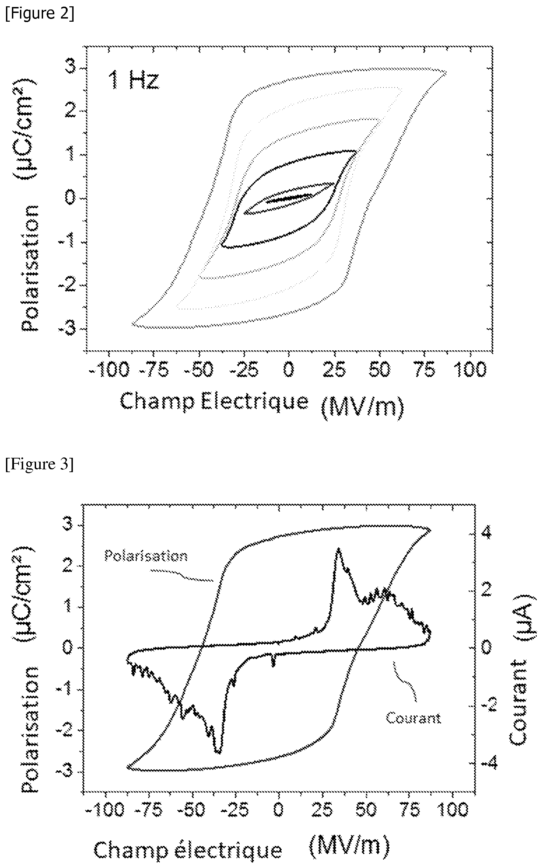

La Figure 2 représente 6 courbes de polarisation obtenues en augmentant progressivement le champ électrique aux bornes de la fibre piézo-électrique. L'effet ferroélectrique est clairement mis en évidence via le phénomène d'hystérèse et l'augmentation de la polarisation rémanente à champ nul. Ces courbes ont été obtenues en faisant varier le champ électrique à une fréquence de 1 Hz.

La Figure 3 représente la courbe de polarisation en $\mu$C/cm$^2$ obtenue pour des valeurs de champ électrique maximal de +86 MV/m et -86 MV/m sous balayage à 1 Hz. Cette figure représente également la courbe du courant (en $\mu$A) obtenue lors de cette polarisation. Les pics de courant correspondent aux valeurs du champ coercitif, champ nécessaire à l'alignement des dipôles électriques, preuve supplémentaire du comportement ferroélectrique et piézoélectrique obtenu.

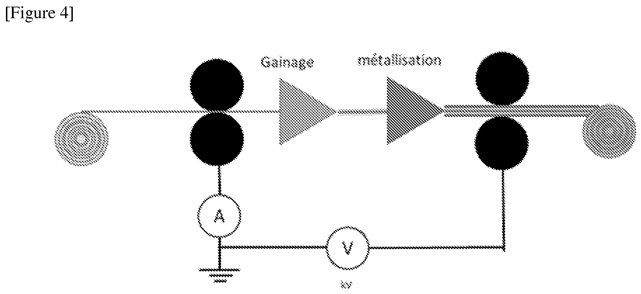

La Figure 4 représente un schéma illustrant la polarisation en une étape avec gainage du polymère piézo-actif et de la contre-électrode à la continue.

DESCRIPTION DE MODES DE REALISATION DE L'INVENTION

L'invention est maintenant décrite plus en détail et de façon non limitative dans la description qui suit.

Selon un premier aspect, l'invention concerne une formulation de gainage telle que définie dans la revendication 1 et comprenant les composants suivants :

a) une solution de copolymère P(VDF-TrFE) à 10-30% massique dans un solvant volatil,
b) un agent tensioactif, et
c) un promoteur d'adhésion.

Selon diverses réalisations, ladite formulation comprend les caractères suivants, le cas échéant combinés.

Copolymère fluoré

Le copolymère fluoré de formule P(VDF-TrFE) consiste en des unités issues du fluorure de vinylidène et des unités issues du trifluoroéthylène. La proportion de motifs issus du TrFE est de préférence de 5 à 95 mol.% par rapport à la somme des motifs issus du VDF et du TrFE, et notamment : de 5 à 10 mol.% ; ou de 10 à 15 mol.% ; ou de 15 à 20 mol.% ; ou de 20 à 25 mol.% ; ou de 25 à 30 mol.% ; ou de 30 à 35 mol.% ; ou de 35 à 40 mol.% ; ou de 40 à 45 mol.% ; ou de 45 à 50 mol.% ; ou de 50 à 55 mol.% ; ou de 55 à 60 mol.% ; 10 ou de 60 à 65 mol.% ; ou de 65 à 70 mol.% ; ou de 70 à 75 mol.% ; ou de 75 à 80 mol.% ; ou de 80 à 85 mol.% ; ou de 85 à 90 mol.% ; ou de 90 à 95 mol.%.

Une gamme de 15 à 55 mol.% est particulièrement préférée.

La composition molaire des motifs dans le copolymère P(VDF-TrFE) peut être déterminée par divers moyens tels que la spectroscopie infrarouge ou la spectroscopie RAMAN. Les méthodes classiques d'analyse élémentaire en éléments carbone, fluor et chlore ou brome ou iode, telle que la spectroscopie à fluorescence X, permettent de calculer la composition massique des polymères, d'où l'on déduit la composition molaire. On peut également mettre en œuvre les techniques de RMN multinoyaux, notamment proton ($^1$H) et fluor ($^{19}$F), par analyse d'une solution du polymère dans un solvant deutéré approprié.

Le copolymère P(VDF-TrFE) est de préférence statistique et linéaire. Il peut être homogène ou hétérogène. Un polymère homogène présente une structure de chaînes uniforme, la répartition statistique des unités issues des différents monomères ne variant pratiquement pas entre les chaînes. Dans un polymère hétérogène, les chaînes présentent une distribution en unités issues des différents monomères de type multimodale ou étalée. Un polymère hétérogène comprend donc des chaînes plus riches en une unité donnée et des chaînes plus pauvres en cette unité.

La température de Curie du copolymère est comprise entre 50 et 145 °C. La température de Curie des polymères de l'invention peut être mesurée par calorimétrie différentielle à balayage ou par spectroscopie diélectrique.

Les copolymères de l'invention peuvent être produits en utilisant tout procédé connu, tel que la polymérisation en émulsion, la polymérisation en microémulsion, la polymérisation en suspension et la polymérisation en solution.

Selon un mode de réalisation, la masse molaire moyenne en poids, qui dans le cadre de cette demande est également désignée par «poids moléculaire» (Mw), du copolymère, vaut de 200 000 à 1 500 000 g/mol, de préférence de 250 000 à 1 000 000 g/mol, et plus particulièrement de 300 000 à 700 000 g/mol.

Cette dernière peut être ajustée par modification de certains paramètres du procédé, tels que la température dans le réacteur, ou par ajout d'un agent de transfert.

La distribution de poids moléculaire peut être estimée par SEC (chromatographie d'exclusion stérique) avec du diméthylformamide (DMF) en tant qu'éluant, avec un ensemble de 3 colonnes de porosité croissante. La phase stationnaire est un gel de styrène-DVB. Le procédé de détection est fondé sur une mesure de l'indice de réfraction, et l'étalonnage est réalisé avec des étalons de polystyrène. L'échantillon est mis en solution à 0,5 g/L dans du DMF et filtré sur un filtre en nylon de 0,45 $\mu$m.

Le poids moléculaire peut également être évalué par mesure de l'indice de fluidité à 230°C sous une charge de 5 kg selon ASTM D1238 (ISO 1133).

Par ailleurs, le poids moléculaire peut également être caractérisé par une mesure de la viscosité en solution selon la norme ISO 1628. La méthyléthylcétone (MEK) est un solvant préféré pour la détermination de l'indice de viscosité.

Dans la formulation de gainage, le copolymère P(VDF-TrFE) est en solution à 10-30% massique dans un solvant volatil.

Ledit solvant volatil est choisi dans la liste :

- les cétones, notamment la méthylisobutylcétone, méthyléthylcétone (MEK), cyclopentanone, acétone,
- les esters, notamment l'acétate d'éthyle, l'acétate de méthyle, l'acétate de propyle, l'acétate de butyle et l'acétate de propylène glycol méthyl éther,
- les amides tels que le diméthylformamide et le diméthylacétamide,
- le diméthylsulfoxyde,
- les furanes, notamment le tétrahydrofurane;
- les carbonates, notamment le diméthylcarbonate,
- les phosphates, notamment le triéthylphosphate,
- et les mélanges de ceux-ci.

Selon un mode de réalisation, ledit solvant volatil est choisi dans le groupe : méthyléthylcétone cyclopentanone, acétone et acétate d'éthyle.

Agent tensioactif

L'agent tensioactif permet d'assurer un mouillage optimal de la solution de copolymère fluoré sur l'âme métallique. Selon un mode de réalisation, ledit tensioactif est du type non-ionique.

Ledit tensio-actif est à base d'un copolymère acrylique (par exemple, le BYK 3440) ou à base de copolymères acryliques à blocs de haut poids moléculaire (par exemple, le Disperbyk 163).

La teneur en agent tensioactif varie de 0,05 à 1% en poids, de préférence de 0,1 à 0,5%, bornes comprises, par rapport au poids de la formulation de gainage.

Promoteur d'adhésion

Le promoteur d'adhésion contribue à l'amélioration du mouillage de la solution de copolymère fluoré sur l'âme métallique, et permet également d'obtenir une gaine adhésive de copolymère sur le filament. Il s'agit d'un polymère fonctionnalisé avec des groupements de type $-NH_2$, -OH, -COOH ou autres groupements associatifs.

Ledit promoteur d'adhésion comprend des copolymères fonctionnels de type hydroxyle avec groupements acides (par exemple, le BYK 4510) ou de liants de type éthoxysilane, par exemple le 3-aminopropyltriéthoxysilane (Dynasylan AMEO).

La teneur massique en promoteur d'adhésion de la formulation de gainage est comprise entre 0,05 et 3%, de préférence comprise entre 0,2 et 0,5%, bornes comprises, par rapport au poids de la formulation de gainage.

La viscosité de la formulation de gainage est comprise entre 1 et 500 Pa.s, de préférence entre 10 et 100 Pa.s, pour un taux de cisaillement de 10 $s^{-1}$. L'utilisation d'une solution de gainage montrant un comportement rhéo-épaississant est avantageuse. La viscosité est mesurée à température ambiante entre 20 et 25 °C à l'aide d'un viscosimètre Brookfield selon la norme ASTM D2983.

Selon un mode de réalisation, la formulation de gainage selon l'invention consiste en ces trois composants a, b et c.

L'invention concerne également un procédé de fabrication en continu, en voie solvant, d'une fibre piézoélectrique composite comprenant un filament métallique recouvert d'une couche de polymère fluoré piézoélectrique, ledit procédé comprenant les étapes suivantes :

i) fournir un fil métallique nu,

ii) enduire ledit fil métallique avec la formulation de gainage selon l'invention, comprenant le passage dudit fil métallique dans une filière de gainage où est injectée ladite formulation de gainage, pour obtenir un fil métallique gainé,

iii) sécher ledit fil métallique gainé pour évaporer le solvant,

iv) chauffer le film métallique gainé séché pour réaliser un recuit thermique.

Le procédé débute par le dévidage d'un fil métallique nu. Le métal doit de préférence avoir une conductivité électrique supérieure à 0,5 MS/m et est choisi dans la liste : cuivre, platine, acier inoxydable et molybdène. Le fil métallique présente un diamètre allant de 50 à 900 $\mu$m, de préférence de 80 à 300 $\mu$m et présente un module d'Young supérieur à 1 GPa ainsi qu'un allongement élastique compris entre 1 et 10 %.

Avantageusement, le fil métallique est dégraissé en bac au moyen d'une solution alcaline, acide, détergente ou à l'alcool. Le fil dégraissé est ensuite séché, puis passé dans une filière de gainage dans laquelle le fil est recouvert d'une fine couche de la formulation de gainage selon l'invention, décrite ci-dessus.

Préférentiellement le procédé est réalisé à la verticale pour permettre un centrage optimal de la formulation de gainage sur le filament. Le débit d'injection est adapté en fonction du diamètre de filament gainé, du diamètre du tube creux, du diamètre de sortie de la filière de gainage, de la viscosité de la solution injectée et de la vitesse de défilement du filament.

Plusieurs passages successifs dans la tête de gainage permettent d'ajuster l'épaisseur de la formulation de gainage à la surface du filament.

L'épaisseur de polymère piézo-électrique obtenue par le procédé de gainage en voie solvant décrit ici est comprise entre 5 et 100 $\mu$m, et de préférence comprise entre 10 et 30 $\mu$m.

La viscosité de la solution de gainage permettant d'obtenir cette épaisseur est idéalement comprise entre 1 et 500 Pa.s pour un taux de cisaillement de 10 s$^{-1}$. L'utilisation d'une solution de gainage ayant une viscosité comprise entre 10 et 100 Pa.s ou montrant un comportement rhéo-épaississant est avantageuse pour obtenir une gaine de polymère adhéré d'épaisseur contrôlée et centrée sur l'âme métallique.

L'adaptation de la rhéologie de la solution formulation de gainage permet d'optimiser l'épaisseur de la couche de polymère sur le filament métallique, l'uniformité de cette couche et de prévenir la formation de porosités. Cette épaisseur varie de 5 et 100 $\mu$m, et est de préférence comprise entre 10 et 30 $\mu$m.

Etape de séchage

Une méthode de séchage peut consister en le passage du filament gainé dans un tunnel d'air chaud soufflé à une température comprise entre 50°C et 150°C, permettant l'évaporation du solvant utilisé pour le gainage.

Etape de recuit

Une fois le fil métallique gainé de la couche de polymère piézoélectrique, une étape de recuit thermique permet d'homogénéiser la structure et de favoriser les propriétés d'adhésion et de comportement piézo-électrique. Cette étape de recuit se fait de préférence à une température comprise entre 80 et 200°C pendant 10 minutes et avantageusement entre 130 et 180 °C pendant 5 minutes.

Ce recuit peut également être réalisé en ligne après séchage de la couche de polymère, par évaporation du solvant, et avant l'étape de bobinage, lors d'une procédure one-step.

Le procédé comprend en outre une étape v) de bobinage du fil métallique gainé, qui peut être réalisée soit avant l'étape de recuit thermique, soit après cette étape.

Dans la fibre composite piézolélectrique comprenant le fil métallique et la couche de polymère fluoré, le fil métallique joue le rôle d'électrode interne. Diverses utilisations de cette fibre piézoélectrique composite nécessitent le dépôt d'une électrode externe sur la gaine en polymère.

Selon un mode de réalisation, le procédé selon l'invention comprend une étape supplémentaire vi) de recouvrement en continu du fil métallique gainé par une contre-électrode.

Dépôt d'électrode externe

Le filament de métal et copolymère P(VDF-TrFE), préparé comme décrit ci-dessus, peut être recouvert par une contre-électrode de façon continue, selon l'une des voies indiquées ci-dessous :

- gainage en voie solvant par une solution de polymère conducteur, par exemple une solution de PEDOT:PSS (PEDOT désigne le poly(3,4-éthylènedioxythiophène) et PSS désigne le poly(styrène sulfonate)), en bain (immersion) ou en filière de gainage ; ou

- gainage en voie liquide à l'aide d'une encre conductrice de type laque d'argent ou vernis carbone (noirs de carbone ou nanocarbones), par immersion ou en filière de gainage ; ou

- gainage en voie fondue par un polymère CPC ; dans ce cas, pas d'étirage et pas d'alignement de charges, la conductivité est supérieure à 100 S/m ; ou

- métallisation par évaporation d'or ou d'un autre métal conducteur ; ou

- guipage d'un fil métallique conducteur autour de la gaine piézoactive; ou

- tressage d'un fil métallique autour de la gaine piézoactive (cordon, corde ...).

Une façon particulièrement avantageuse permettant d'obtenir une électrode externe conductrice et déposée de façon continue sur le polymère piezoélectrique, consiste en l'utilisation d'une solution aqueuse de PEDOT:PSS filmifiée. Ceci peut par exemple s'obtenir par le défilement du fil à recouvrir dans la solution de polymère conducteur mentionnée, suivi de son séchage par évaporation avant bobinage.

Cette opération de dépôt d'électrode externe peut avantageusement être conduite en ligne à la suite des étapes de séchage et de recuit précédemment décrites, avant l'étape de bobinage.

Le procédé selon l'invention comprend en outre une étape vii) de polarisation du polymère piézo-électrique déposé à la surface de l'âme métallique.

Une fois le polymère piézo-électrique déposé à la surface de l'âme métallique, il est nécessaire de polariser le matériau fluoré sous champ électrique afin d'obtenir une réponse piézo-électrique macroscopique du dispositif.

Cette polarisation peut se faire de plusieurs façons, soit avant soit après le dépôt de l'électrode externe.

Polarisation sans contre-électrode à la continue

Cette opération consiste en l'application d'un champ électrique entre la surface de la couche de polymère adhérée et l'âme métallique centrale. Pour ce faire, deux méthodes sont classiquement employées par l'homme du métier : la polarisation au contact et la polarisation sans contact.

Selon un mode de réalisation, la polarisation à la continue est avec contact et comprend les étapes suivantes :

- connecter le fil conducteur nu à un potentiel nul (masse - terre) soit en mettant à la masse la bobine de fil métallique, soit par un système de rouleaux de contact lui-même relié à la masse ;
- gainer le polymère piézoactif par recouvrement du fil d'une solution de polymère suivie de l'évaporation du solvant décrite précédemment, et
- faire passer le fil revêtu sur un système de rouleaux conducteurs électriques, portés à haut potentiel électrique de sorte à ce que le champ électrique aux bornes du revêtement polymère soit compris entre 20 et 200 MV/m.

Selon un autre mode de réalisation, la polarisation à la continue est sans contact et utilise l'effet corona. Une polarisation efficace des polymères fluorés de la présente invention est réalisée à des valeurs de champs électrique élevée de l'ordre de 100 V/$\mu$m. Or, le champ électrique maximal applicable dans l'air avant calquage est d'environ 3 V/$\mu$m. Au de-là de cette valeur, on observe une décharge par ionisation de l'air compris entre les deux pôles, soumis à une forte différence de potentiel, avec création d'un plasma atmosphérique et dégagement d'ozone. C'est ce mécanisme qui est utilisé dans la méthode polarisation corona.

Un dispositif permettant de polariser une fibre à la continue est décrit dans WO2014161920 où un tunnel corona sert d'électrode d'externe. Ce tunnel corona est constitué de nombreuses aiguilles conductrices soumises à un fort potentiel électrique. L'âme conductrice de la fibre piézoélectrique est quant à elle connectée à la masse. La distance entre les électrodes aiguilles et la surface fluorée de la fibre est gardée constante, et un champ électrique supérieur à 3 V/$\mu$m est appliqué entre les deux pôles électriques du système. Une décharge électrique par ionisation de l'air entre l'aiguille et la surface fluorée est obtenue. La surface fluorée se charge alors à haut potentiel sous l'effet de cette décharge, qui contribue ainsi à polariser localement le polymère à des champs largement supérieurs à 3 V/$\mu$m.

Selon un mode de réalisation, un diffuseur de champ / plasma est intercalé entre l'aiguille corona et la surface à polariser ; il s'agit d'une grille métallique conductrice. Cette grille joue le rôle de diffuseur du champ électrique généré par les aiguilles corona, trop localisé, et permet d'avoir une polarisation plus homogène sur la surface en regard de l'électrode.

Polarisation avec contre-électrode à la continue

Une contre-électrode a été déposée à la continue comme décrit ci-dessus.

Selon un mode de réalisation, la polarisation en ligne comprend les étapes suivantes

- connecter le fil conducteur nu à un potentiel nul (masse - terre) soit en mettant à la masse la bobine de fil métallique, soit par un système de rouleaux de contact lui-même relié à la masse ;
- gainer le polymère piézoactif par recouvrement du fil d'une solution de polymère suivie de l'évaporation du solvant décrite précédemment ;
- déposer la contre-électrode, et
- faire passer le fil revêtu sur un système de rouleaux conducteurs électriques, portés à haut potentiel électrique de sorte à ce que le champ électrique aux bornes du revêtement polymère soit compris entre 20 et 200 MV/m.

Selon un autre mode de réalisation, la polarisation se fait en une étape (one-step) à l'issue du dépôt de la contre -électrode en ligne.

Ce mode de réalisation est illustré par le schéma de la figure 4.

L'invention permet de produire une fibre piézoélectrique composite comprenant une écorce de polymère fluoré électroactif qui adhère sur une âme métallique. Avantageusement, la fibre présente une déformation élastique comprise entre 1 et 5%. La couche de polymère fluoré est polarisée et peut être recouverte d'une électrode externe en métal ou polymère conducteur.

La fibre piézoélectrique composite peut être utilisée dans diverses applications comme la fabrication de textiles techniques, la filtration des fluides, et dans l'électronique.

Une fibre composée d'un polymère fluoré et ayant une âme conductrice, constituant une première électrode, et un revêtement extérieur conducteur constituant une seconde électrode peut ainsi constituer un actionneur. L'application d'un champ électrique entre ces électrodes permet de modifier les caractéristiques mécaniques de la fibre. Si cette fibre est intégrée dans une structure textile, l'application de ce champ électrique permet de modifier les caractéristiques mécaniques de cette structure textile.

EXEMPLES

Les exemples suivants illustrent l'invention sans la limiter.

**Exemple 1. Fabrication de fibres** illustrant les clichés de MEB de la figure 1.

Une solution concentrée à 20 w% de copolymère VDF-TrFE (80-20) dans la MEK est obtenue par dissolution à froid. À cette solution sont ajoutés 1% de Disperbyk 3440 ainsi que 0.2% de promoteur d'adhérence DynaSylan Ameo. (triethoxysilane) à froid.

Cette solution est utilisée pour gainer un filament de cuivre de $700\,\mu m$ de diamètre à la continue, suivi d'une étape de séchage à 80 °C puis d'un recuit à 135 °C dans 2 fours séparés en ligne. La fibre est enfin bobinée.

La formulation optimisée et le procédé de gainage en voie solvant permettent d'obtenir des filaments de cuivre nus gainés par le copolymère de façon adhésive sans utilisation d'émaillage isolant ni de procédé de mouillage par application de champ électrique.

**Exemple 2: Fabrication d'un dispositif piézoélectrique de fibre à âme métallique**

Une fibre piézoélectrique est fabriquée selon l'invention. Elle est constituée : d'un filament de cuivre de 200 $\mu$m de diamètre, constituant l'électrode interne ; d'une couche de 20 $\mu$m d'un copolymère P(VDF-TrFE) ayant 20% molaire de TrFE, qui adhère au filament ; et d'une couche de vernis conducteur de carbone déposée manuellement à la surface du polymère fluoré, constituant l'électrode externe.

Le dispositif est connecté électriquement, les contacts électriques sont assurés au moyens de pointes ou de pinces crocodiles plates compatible haute tension. Une pointe est reliée à l'âme métallique et mise à la masse, l'autre pointe contactée à l'électrode externe soumise à un potentiel variable.

L'aire en regard des deux électrodes s'exprime par l'équation :

$$S = \pi \, \phi \, L$$

où : f est diamètre de l'âme métallique et L est la distance entre les électrodes

Lorsque L = 5 cm, on obtient: $S = \pi \times 200.10^{-6} \times 5.10^{-2} = 31{,}42\ mm^2$.

Ce dispositif est ensuite polarisé « off-line » avec l'application d'une tension sinusoïdale croissante d'une fréquence de 1 Hz, jusqu'à 100 MV/m, soit 2000 V pour l'échantillon d'épaisseur 20 $\mu$m. Lors de la polarisation, les valeurs de champ électrique et de courant sont enregistrées.

L'effet ferroélectrique est clairement mis en évidence via le phénomène d'hystérèse et l'augmentation de la polarisation rémanente à champ nul (voir Figure 2). Les pics de courant mesurés correspondent aux valeurs du champ coercitif, champ nécessaire à l'alignement des dipôles électriques, indiquent qu'un comportement ferroélectrique et piézo-électrique est obtenu. (Figure 3).

Ces dispositifs peuvent également être soumis à des sollicitations mécaniques cycliques (DMA, traction, flexion....).

**Revendications**

**1.** Formulation de polymère de gainage d'une âme métallique comprenant les composants suivants :

a) une solution de copolymère P(VDF-TrFE) à 10-30% massique dans un solvant volatil,
b) un agent tensioactif ledit agent tensioactif étant à base d'un copolymère acrylique ou à base de copolymères acryliques à blocs de haut poids moléculaire , et
c) un promoteur d'adhésion, ledit promoteur d'adhésion comprenant des copolymères fonctionnels de type hydroxyle avec groupements acides ou de liants de type éthoxysilane, par exemple le 3-aminopropyltriéthoxysilane;

la viscosité de la formulation de gainage, telle que mesurée à température ambiante entre 20°C et 25°C à l'aide d'un viscosimètre Brookfield selon la norme ASTM D2983, étant comprise entre 1 et 500 Pa.s, de préférence entre 10 et 100 pour un taux de cisaillement de 10 s$^{-1}$ ;
ledit solvant volatil est choisi dans la liste :

- les cétones, notamment la méthylisobutylcétone, méthyléthylcétone (MEK), cyclopentanone, acétone,
- les esters, notamment l'acétate d'éthyle, l'acétate de méthyle, l'acétate de propyle, l'acétate de butyle et l'acétate de propylène glycol méthyl éther,
- les amides tels que le diméthylformamide et le diméthylacétamide,
- le diméthylsulfoxyde,
- les furanes, notamment le tétrahydrofurane;
- les carbonates, notamment le diméthylcarbonate,
- les phosphates, notamment le triéthylphosphate,
- et les mélanges de ceux-ci.

2. Formulation selon la revendication 1, dans laquelle le copolymère P(VDF-TrFE consiste en des unités issues du VDF et du TrFE, la proportion de motifs issus du TrFE allant de 5 à 95 mol.% par rapport à la somme des motifs issus du VDF et du TrFE, de préférence de 15 à 55 mol.%.

3. Formulation selon l'une des revendications 1 et 2, dans laquelle l'agent tensioactif a une teneur qui varie de 0,05 à 1% en poids, de préférence de 0,1 à 0,5%, par rapport au poids de la formulation de gainage.

4. Formulation selon l'une des revendications 1 à 3, dans laquelle ledit promoteur d'adhésion a une teneur massique étant comprise entre 0,05 et 3%, de préférence comprise entre 0,2 et 0,5% par rapport au poids de la formulation de gainage.

5. Formulation selon l'une des revendications 1 à 4 consistant en les composants a), b) et c).

6. Procédé de fabrication en continu, en voie solvant, d'une fibre piézoélectrique composite comprenant un filament métallique recouvert d'une couche de polymère fluoré piézoélectrique, ledit procédé comprenant les étapes suivantes :

i. fournir un fil métallique nu,
ii. enduire ledit fil métallique avec la formulation de gainage selon l'une des revendications 1 à 5, comprenant le passage dudit fil métallique dans une filière de gainage où est injectée ladite formulation de gainage, pour obtenir un fil métallique gainé,
iii. sécher ledit fil métallique gainé pour évaporer le solvant,
iv. chauffer le film métallique gainé séché pour réaliser un recuit thermique.

7. Procédé selon la revendication 6, dans lequel le fil métallique nu est choisi dans la liste :
cuivre, platine, acier inoxydable, molybdène, et présente un diamètre allant de 50 à 900 μm, de préférence de 80 à 300 μm.

8. Procédé selon l'une des revendications 6 et 7, dans lequel l'épaisseur de la formulation de gainage à la surface du filament est ajustée par des passages successifs dans la tête de gainage, ladite épaisseur étant comprise entre 5 et 100 μm, et de préférence comprise entre 10 et 30 μm.

9. Procédé selon l'une des revendications 6 à 8 comprenant une étape v) de bobinage du fil métallique gainé, qui peut être réalisée soit avant l'étape de recuit thermique, soit après cette étape.

10. Procédé selon l'une des revendications 6 à 9 comprenant une étape vi) de recouvrement en continu du fil métallique gainé par une contre-électrode.

11. Procédé selon la revendication 10, dans lequel la formation de l'électrode externe se fait selon l'une des voies indiquées ci-dessous :

- gainage en voie solvant par une solution de polymère conducteur ou en filière de gainage ;
- gainage en voie liquide à l'aide d'une encre conductrice de type laque d'argent ou vernis carbone, par immersion ou en filière de gainage ;
- gainage en voie fondue par un polymère CPC ;
- métallisation par évaporation d'or ou d'un autre métal conducteur ;
- guipage d'un fil métallique conducteur autour de la gaine piézoactive;
- tressage d'un fil métallique autour de la gaine piézoactive.

12. Procédé selon l'une des revendications 6 à 11 comprenant en outre une étape vii) de polarisation à la continue du polymère piézo-électrique déposé à la surface de l'âme métallique, cette étape étant réalisée soit avant soit après le dépôt de l'électrode externe.

13. Procédé selon la revendication 12 dans lequel la polarisation à la continue sans électrode externe est avec contact et comprend les étapes suivantes :

- connecter le fil conducteur nu à un potentiel nul (masse - terre) soit en mettant à la masse la bobine de fil métallique, soit par un système de rouleaux de contact lui-même relié à la masse ;
- gainer le polymère piézoactif ;
- faire passer le fil revêtu sur un système de rouleaux conducteurs électriques, lui-même porté à haut potentiel électrique.

14. Procédé selon la revendication 12 dans lequel la polarisation à la continue sans électrode externe est sans contact et comprend les étapes suivantes :

- créer un tunnel corona constitué d'aiguilles conductrices soumises à un fort potentiel électrique ;
- connecter l'âme conductrice de la fibre piézoélectrique à la masse ;
- gardée constante la distance entre les électrodes aiguilles et la couche de polymère fluoré de la fibre ;
- appliquer un champ électrique supérieur à 3 V/μm entre les deux pôles électriques du système, conduisant à la formation d'une décharge électrique par ionisation de l'air entre l'aiguille et la surface fluorée qui devient chargée.

15. Procédé selon la revendication 12 dans lequel la polarisation à la continue est effectuée après le dépôt de l'électrode externe.

**Patentansprüche**

1. Polymerformulierung zum Ummanteln eines Metallkerns, welche die folgenden Komponenten umfasst:

a) eine Lösung des Copolymers P(VDF-TrFE) mit 10-30 Gew.-% in einem flüchtigen Lösungsmittel,
b) ein Tensid, wobei das Tensid auf einem AcrylCopolymer oder Acryl-Block-Copolymeren mit einer hohen Molmasse basiert, und
c) einen Haftungsvermittler, wobei der Haftungsvermittler funktionelle Copolymere vom Hydroxyltyp mit Säuregruppen oder Bindemittel vom Ethoxysilantyp, beispielsweise 3-Aminopropyltriethoxysilan, umfasst;

wobei die bei einer Umgebungstemperatur zwischen 20 °C und 25 °C mittels eines Brookfield-Viskosimeters gemäß der Norm ASTM D2983 gemessene Viskosität der Ummantelungsformulierung für eine Scherrate von 10 s$^{-1}$ zwischen 1 und 500, vorzugsweise zwischen 10 und 100 Pa.s, beträgt;
das flüchtige Lösungsmittel aus der folgenden Liste ausgewählt ist:

- Ketonen, insbesondere Methylisobutylketon, Methylethylketon (MEK), Cyclopentanon, Aceton,
- Estern, insbesondere Ethylacetat, Methylacetat, Propylacetat, Butylacetat und Propylenglycolmethyletheracetat,
- Amiden, wie Dimethylformamid und Dimethylacetamid,
- Dimethylsulfoxid,
- Furanen, insbesondere Tetrahydrofuran;
- Carbonaten, insbesondere Dimethylcarbonat,
- Phosphaten, insbesondere Triethylphosphat,
- und Mischungen davon.

2. Formulierung nach Anspruch 1, wobei das Copolymer P(VDF-TrFE) aus Einheiten aus VDF und TrFE besteht, wobei der Anteil der Repetiereinheiten aus TrFE von 5 bis 95 Mol-%, bezogen auf die Summe der Repetiereinheiten aus VDF und TrFE, vorzugsweise von 15 bis 55 Mol-%, beträgt.

3. Formulierung nach einem der Ansprüche 1 und 2, wobei das Tensid einen Gehalt aufweist, der von 0,05 bis 1 Gew.-%, vorzugsweise von 0,1 bis 0,5 %, reicht, bezogen auf das Gewicht der Umhüllungsformulierung,

4. Formulierung nach einem der Ansprüche 1 bis 3, wobei der Haftungsvermittler einen Massengehalt zwischen 0,05 und 3 %, vorzugsweise zwischen 0,2 und 0,5 %, bezogen auf das Gewicht der Ummantelungsformulierung, aufweist.

5. Formulierung nach einem der Ansprüche 1 bis 4, die aus den Komponenten a), b) und c) besteht.

6. Lösungsmittelbasiertes Verfahren zur kontinuierlichen Herstellung einer piezoelektrischen Verbundfaser, die ein mit einer Schicht eines piezoelektrischen Fluorpolymers beschichtetes Metallfilament umfasst, wobei das Verfahren die folgenden Schritte umfasst:

i. das Bereitstellen eines blanken Metalldrahts,
ii. das Beschichten des Metalldrahts mit der Ummantelungsformulierung nach einem der Ansprüche 1 bis 5, welches das Durchlaufen des Metalldrahts durch eine Ummantelungsdüse, in der die Ummantelungsformulierung eingespritzt wird, umfasst, um einen ummantelten Metalldraht zu erhalten,
iii. das Trocknen des ummantelten Metalldrahts zum Verdampfen des Lösungsmittels,
iv. das Erwärmen des getrockneten ummantelten Metalldrahts, um ein thermisches Tempern durchzuführen.

7. Verfahren nach Anspruch 6, wobei der blanke Metalldraht aus der folgenden Liste: Kupfer, Platin, Edelstahl, Molybdän ausgewählt ist und einen Durchmesser von 50 bis 900 $\mu$m, vorzugsweise von 80 bis 300 $\mu$m, aufweist.

8. Verfahren nach einem der Ansprüche 6 und 7, wobei die Dicke der Ummantelungsformulierung auf der Oberfläche des Filaments durch aufeinanderfolgende Durchläufe durch den Ummantelungskopf eingestellt wird, wobei die Dicke zwischen 5 und 100 $\mu$m und vorzugsweise zwischen 10 und 30 $\mu$m beträgt.

9. Verfahren nach einem der Ansprüche 6 bis 8, das einen Schritt v) eines Wickelns des ummantelten Metalldrahts umfasst, das entweder vor dem Schritt des thermischen Temperns oder nach diesem Schritt durchgeführt werden kann.

10. Verfahren nach einem der Ansprüche 6 bis 9, das einen Schritt vi) eines kontinuierlichen Beschichtens des ummantelten Metalldrahts mit einer Gegenelektrode umfasst.

11. Verfahren nach Anspruch 10, wobei die Bildung der äußeren Elektrode nach einem der nachfolgend aufgeführten Wege erfolgt:

- einem lösungsmittelbasierten Ummanteln mit einer Lösung eines leitfähigen Polymers oder in einer Ummantelungsdüse;
- einem flüssigkeitsbasierten Ummanteln mit einer leitfähigen Tinte vom Typ eines Silberlacks oder Carbonlacks durch Tauchen oder in einer Ummantelungsdüse;
- einem schmelzbasierten Ummanteln mit einem CPC-Polymer;
- einem Metallisieren durch Aufdampfen von Gold oder einem anderen leitfähigen Metall;
- einem Umwickeln der piezoaktiven Ummantelung mit einem leitfähigen Metalldraht;
- einem Umflechten der piezoaktiven Ummantelung mit einem Metalldraht.

12. Verfahren nach einem der Ansprüche 6 bis 11, das außerdem einen Schritt vii) des kontinuierlichen Erzeugens einer Vorspannung in dem auf der Oberfläche des Metallkerns abgeschiedenen piezoelektrischen Polymer umfasst, wobei dieser Schritt entweder vor oder nach der Abscheidung der äußeren Elektrode durchgeführt wird.

13. Verfahren nach Anspruch 12, wobei die kontinuierliche Erzeugung einer Vorspannung ohne äußere Elektrode mit einem Kontakt erfolgt und die folgenden Schritte umfasst:

- das Verbinden des blanken leitfähigen Drahts mit einem Nullpotential (Masse - Erde) entweder, indem die Metalldrahtspule geerdet wird, oder mit einem Kontaktwalzensystem, das selbst geerdet ist;
- das Ummanteln mit dem piezoaktiven Polymer;
- das Leiten des beschichteten Drahts über ein System von elektrisch leitfähigen Rollen, die selbst auf einem hohen elektrischen Potential gehalten werden.

14. Verfahren nach Anspruch 12, wobei die kontinuierliche Erzeugung einer Vorspannung ohne äußere Elektrode ohne einen Kontakt erfolgt und die folgenden Schritte umfasst:

- das Erzeugen eines Coronatunnels, der aus leitfähigen Nadeln besteht, auf die ein starkes elektrisches Potential einwirkt;
- das Verbinden des leitfähigen Kerns der piezoelektrischen Faser mit der Masse;
- das konstante Beibehalten des Abstands zwischen den Nadelelektroden und der Schicht des fluorierten Polymers der Faser;
- das Anlegen eines elektrischen Feldes von mehr als 3 V/$\mu$m zwischen den beiden elektrischen Polen des Systems, was zur Bildung einer elektrischen Entladung durch Ionisierung der Luft zwischen der Nadel und der fluorierten Oberfläche führt, die geladen wird.

15. Verfahren nach Anspruch 12, wobei die kontinuierliche Erzeugung einer Vorspannung nach der Abscheidung der äußeren Elektrode erfolgt.

**Claims**

1. Polymer formulation for coating a metal core, comprising the following components:

a) a P(VDF-TrFE) copolymer solution at 10-30% by mass in a volatile solvent,
b) a surfactant, said surfactant being based on an acrylic copolymer or based on high molecular weight block acrylic copolymers, and
c) an adhesion promoter, said adhesion promoter comprising functional copolymers of hydroxyl type with acid groups or binders of ethoxysilane type, for example 3-aminopropyltriethoxysilane;

the viscosity of the coating formulation, as measured at ambient temperature between 20°C and 25°C using a Brookfield viscometer according to Standard ASTM D2983, being between 1 and 500 Pa.s and preferably between 10 and 100 Pa.s, for a shear rate of 10 s$^{-1}$; said volatile solvent being chosen from the following list:

- ketones, notably methyl isobutyl ketone, methyl ethyl ketone (MEK), cyclopentanone and acetone,
- esters, notably ethyl acetate, methyl acetate, propyl acetate, butyl acetate and propylene glycol methyl ether acetate,
- amides such as dimethylformamide and dimethylacetamide,
- dimethyl sulfoxide,
- furans, notably tetrahydrofuran,
- carbonates, notably dimethyl carbonate,
- phosphates, notably triethyl phosphate,
- and mixtures thereof.

2. Formulation according to Claim 1, in which the P(VDF-TrFE) copolymer consists of units derived from VDF and from TrFE, the proportion of units derived from TrFE ranging from 5 mol% to 95 mol% relative to the sum of the units derived from VDF and from TrFE, preferably from 15 mol% to 55 mol%.

3. Formulation according to either of Claims 1 and 2, in which the surfactant has a content which ranges from 0.05% to 1% by weight and preferably from 0.1% to 0.5% by weight, relative to the weight of the coating formulation.

4. Formulation according to one of Claims 1 to 3, in which said adhesion promoter has a mass content between 0.05% and 3%, preferably between 0.2% and 0.5%, relative to the weight of the coating formulation.

5. Formulation according to one of Claims 1 to 4, consisting of components a), b) and c).

6. Solvent-based process for the continuous manufacture of a composite piezoelectric fibre comprising a metal filament covered with a layer of piezoelectric fluoropolymer, said process comprising the following steps:

i. providing a bare metal wire,
ii. coating said metal wire with the coating formulation according to one of Claims 1 to 5, comprising the passage of said metal wire through a coating nozzle where said coating formulation is injected, to obtain a coated metal wire,
iii. drying said coated metal wire to evaporate the solvent,
iv. heating the dried coated metal wire to achieve thermal annealing.

7. Process according to Claim 6, in which the bare metal wire is chosen from the following list: copper, platinum, stainless steel, molybdenum, and has a diameter ranging from 50 to 900 $\mu$m, preferably from 80 to 300 $\mu$m.

8. Process according to either of Claims 6 and 7, in which the thickness of the coating formulation at the surface of the filament is adjusted by successive passages through the coating head, said thickness being between 5 and 100 $\mu$m, and preferably between 10 and 30 $\mu$m.

9. Process according to one of Claims 6 to 8, comprising a step v) of winding the coated metal wire, which may be performed either before the thermal annealing step or after this step.

10. Process according to one of Claims 6 to 9, comprising a step vi) of continuously covering the coated metal wire with a counterelectrode.

11. Process according to Claim 10, in which the formation of the outer electrode takes place according to one of the routes indicated below:

- solvent-based coating with a conductive polymer solution or in a coating nozzle;
- liquid-based coating using a conductive ink of silver lacquer or carbon varnish type, by immersion or in a coating nozzle;
- melt-route coating with a CPC polymer;
- metallization by evaporation of gold or of another conductive metal;
- binding of a conductive metal wire around the piezoactive coat;
- braiding of a metal wire around the piezoactive coat.

12. Process according to one of Claims 6 to 11, also comprising a step vii) of DC biasing of the piezoelectric polymer deposited on the surface of the metal core, this step being performed either before or after the deposition of the outer electrode.

13. Process according to Claim 12, in which the DC biasing without an outer electrode is with direct contact and comprises the following steps:

- connecting the bare conductive wire to a zero potential (ground - earth) either by earthing the metal wire reel, or by a contact roller system which is itself earthed;
- coating the piezoactive polymer;
- passing the coated wire over a system of electrically conductive rollers, which is itself maintained at a high electric potential.

14. Process according to Claim 12, in which the DC biasing without an outer electrode is contactless and comprises the following steps:

- creating a corona tunnel consisting of conductive needles subjected to a high electric potential;
- earthing the conductive core of the piezoelectric fibre;
- keeping a constant distance between the needle electrodes and the fluoropolymer layer of the fibre;
- applying an electric field of greater than 3 V/$\mu$m between the two electric poles of the system, leading to the formation of an electric discharge by ionization of the air between the needle and the fluorinated surface which becomes charged.

15. Process according to Claim 12, in which the DC biasing is performed after the deposition of the outer electrode.

14

[Figure 1]

a

b

c

d

[Figure 2]

[Figure 3]

[Figure 4]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2018224583 A
- WO 2014161920 A